# FASCICULE DE BREVET EUROPEEN

(11) **EP 1 467 603 B1**
(45) Date de publication et mention de la délivrance du brevet: **15.12.2010**
(21) Numéro de dépôt: 04007028.6
(22) Date de dépôt: 24.03.2004
(51) Int. Cl.: H05K 1/02, H05K 1/11, H02H 5/04, H01H 37/76

(54) **Protection contre la surchauffe sur une plaque de circuit imprimé**
Schutz gegen Überhitzung auf einer Leiterplatte
Protection against overheating on a printed circuit board

(30) Priorité: 08.04.2003 FR 0304331
(43) Date de publication de la demande: 13.10.2004
(73) Titulaire: Valeo Systèmes Thermiques, 78320 Le Mesnil-Saint-Denis (FR)
(72) Inventeur: Dupre de Boulois, Renaud, 75018 Paris (FR); Colette, Olivier, 78320 Le Mesnil-Saint-Denis (FR); Sardat, Pierre, 93340 Le Raincy (FR); Marange, Christophe, 78400 Chatou (FR)
(74) Mandataire: Vieillevigne, Sébastien Nicolas Bernard

(56) Documents cités:
- FR-A- 2 481 011
- US-A- 4 856 060
- US-A- 4 982 892
- US-A- 5 311 164
- US-A- 5 414 219
- US-B1- 6 377 468

## Description

### Domaine de l'invention

La présente invention se rapporte au domaine du montage sur circuit imprimé des composants de puissance et elle concerne plus particulièrement une architecture de circuit imprimé assurant une protection contre les risques d'inflammation en cas de dysfonctionnement de ces composants de puissance.

### Art antérieur

Les composants de puissance montés sur les circuits imprimés ne bénéficient en général d'aucune protection particulière contre les dysfonctionnements dont ils peuvent être affectés. Toutefois, exceptionnellement lorsqu'une telle protection existe, elle consiste le plus souvent en un interrupteur thermique externe au circuit imprimé dont le coût est élevé et dont les conditions de fonctionnement en température sont peu adaptées du fait de l'éloignement existant entre cet interrupteur thermique et le composant à protéger. Or, les dysfonctionnements au niveau de composants de puissance, tels que les diodes ou les transistors, sont relativement fréquentes et de nature à provoquer une destruction non seulement de ces composants mais aussi des circuits qui les entourent, voire du produit dans lequel ils sont incorporés, lorsque du fait de la chaleur dégagée par ces dysfonctionnements, les brasures maintenant ces composants de puissance en contact avec le circuit imprimé fondent.

US 6 377 468, US 5 311 164, US 4 856 060 et FR 2 481 011 représentent des exemples de l'art antérieur.

### Objet et définition de I'invention

La présente invention a donc pour objet de pallier les inconvénients précités en proposant une architecture de circuit imprimé simple et fiable évitant tout risque d'inflammation de ce circuit en cas de fonte des brasures de maintien des composants de puissance.

Ces buts sont atteints par une plaque de circuit imprimé comportant des composants électroniques montés sur cette plaque, dont au moins un composant de puissance comportant au moins une première et une seconde broches externes reliées par des moyens de fixation à des conducteurs imprimés sur cette plaque, **caractérisée en ce qu**'elle comporte en outre une piste conductrice s'étendant depuis une première pastille conductrice de ladite plaque destinée à recevoir ladite première broche externe du composant de puissance vers une seconde pastille conductrice de ladite plaque destinée à recevoir ladite seconde broche externe du composant de puissance, et des moyens de déplacement du composant de puissance pour, en cas de fonte desdits moyens de fixation, former un contact électrique entre lesdites première et seconde pastilles conductrices. Ces première et seconde broches externes du composant de puissance comportent des broches de source et de drain, ou de collecteur et d'émetteur ou encore d'anode et de cathode.

Cette structure particulièrement simple en créant un court-circuit franc entre deux broches du composant de puissance lors de la fonte des brasures de maintien de ce composant sur sa plaque de circuit imprimé, a pour effet de limiter immédiatement la surchauffe de ce composant et de supprimer tout risque d'inflammation.

Selon le mode de réalisation envisagé, ladite piste conductrice supplémentaire peut présenter une forme annulaire entourant ladite pastille conductrice de drain, de collecteur ou de cathode ou une forme en U ou en T entourant en partie ladite pastille conductrice de drain, de collecteur ou de cathode.

De même, les moyens de déplacement peuvent être constitués par la seule gravité (avantageusement lorsque la plaque de circuit imprimé est disposée verticalement) ou comporter un moyen élastique (de préférence une lame ressort) monté sur la plaque isolante et destiné à déplacer le composant de puissance lorsque les brasures qui le maintiennent sur ladite plaque isolante fondent.

L'invention concerne également un procédé de protection d'une plaque de circuit imprimé contre la surchauffe de composants de puissance montés sur cette plaque et reliés par des moyens de fixation à des conducteurs imprimés sur cette plaque, **caractérisé en ce que**, lorsque lesdits moyens de fixation fondent sous l'effet d'une surchauffe du composant de puissance, on déplace le composant de puissance d'une première position dans laquelle il est opérationnel vers une seconde position dans laquelle il est mis en court-circuit.

### Brève description des dessins

Les caractéristiques et avantages de la présente invention ressortiront mieux de la description suivante, faite à titre indicatif et non limitatif, en regard des dessins annexés sur lesquels :
- les figures 1 et 2 illustrent le montage d'un composant de puissance sur un circuit imprimé selon un premier mode de réalisation de l'invention,
- la figure 3 est une variante de réalisation du circuit imprimé de la figure 1,
- la figure 4 illustre le montage d'un composant de puissance sur un circuit imprimé selon un second mode réalisation de l'invention,
- les figures 5 et 6 montrent la disposition du composant de puissance avant et après son déplacement, et
- la figure 7 illustre le montage d'un composant de puissance sur un circuit imprimé selon l'art antérieur.

### Description détaillée d'un mode de réalisation préférentiel

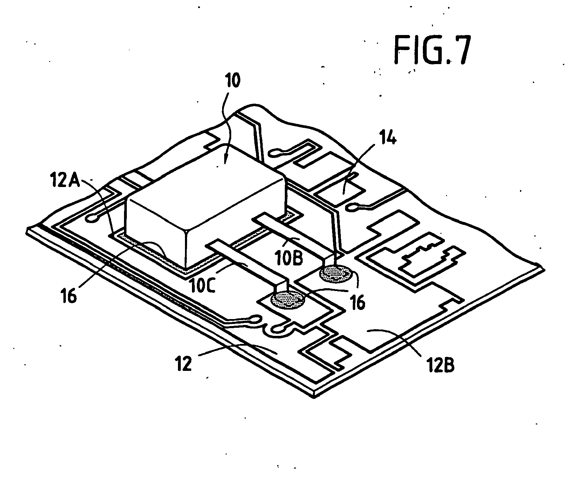

La figure 7 illustre une architecture conventionnelle de circuit imprimé dit double face dans laquelle un composant de puissance 10 est monté sur une face supérieure d'une plaque 12 de circuit isolant comportant des conducteurs ou pistes conductrices 14 avec lesquelles il est mis en contact électrique au travers de ces broches externes. Ce contact électrique est assuré classiquement par des moyens de fixation à chaud, par exemple par brasure ou soudure 16. Dans l'exemple illustré qui ne saurait être limitatif, le composant de puissance, par exemple un transistor MOSFET, comporte un boîtier ou semelle métallique 10A formant broche de drain, une broche de source 10B et une broche de grille 10C. Ces différentes broches du composant de puissance sont en contact avec les différentes pistes conductrices du circuit imprimé, et notamment respectivement avec une pastille conductrice de drain 12A, une pastille conductrice de source 12B et une pastille conductrice de grille 12C, de façon à le fixer dans une position dans laquelle il est opérationnel.

En cas de défaillance, par exemple une surtension, au niveau du composant de puissance, la chaleur dégagée par cet élément va entraîner une fonte des brasures maintenant les broches de ce composant aux pistes conductrices du circuit imprimé et le contact éventuel de ces brasures chaudes, avec par exemple des fils électriques qui les entourent, est de nature à provoquer un début d'inflammation de ces fils.

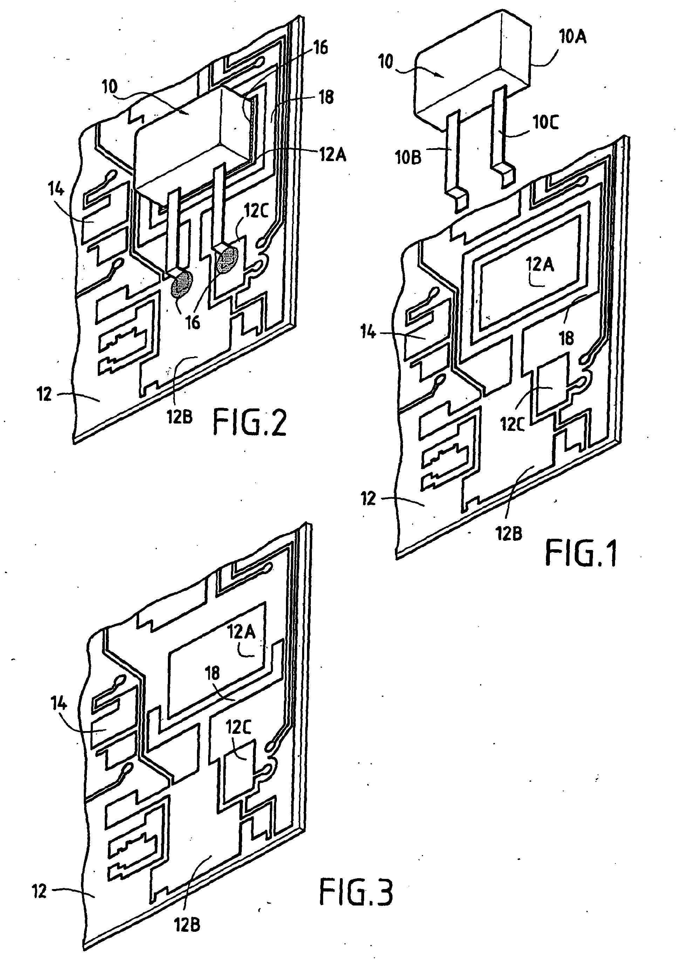

Aussi, selon l'invention, et comme l'illustre le mode de réalisation préférentiel des figures 1 et 2, le circuit imprimé 12 est muni d'une piste conductrice supplémentaire 18 entourant la pastille de drain 12A et reliée électriquement à la pastille de source 12B. Avec cette architecture spécifique, et sous réserve d'une disposition verticale du circuit imprimé, lorsque le composant de puissance est défaillant, ce qui provoque un début de fonte des brasures 16 qui le maintiennent à ce circuit imprimé par l'intermédiaire de ses broches externes, la semelle formant broche de drain de ce composant a tendance naturellement à glisser sous l'effet de la gravité et donc à venir en contact avec la piste supplémentaire 18 entourant la pastille de drain 12A, comme le montre la figure 2, créant au niveau du composant de puissance un court-circuit franc entre ses broches de drain et de source, qui supprime alors toute source d'échauffement.

On notera que la forme de la piste conductrice supplémentaire ne saurait être limitée à la forme annulaire des figures 1 et 2 et qu'une forme plus simple en U entourant en partie seulement la pastille de drain 12A U et s'étendant depuis la zone de source 12B, comme illustrée à la figure 3, peut tout à fait convenir.

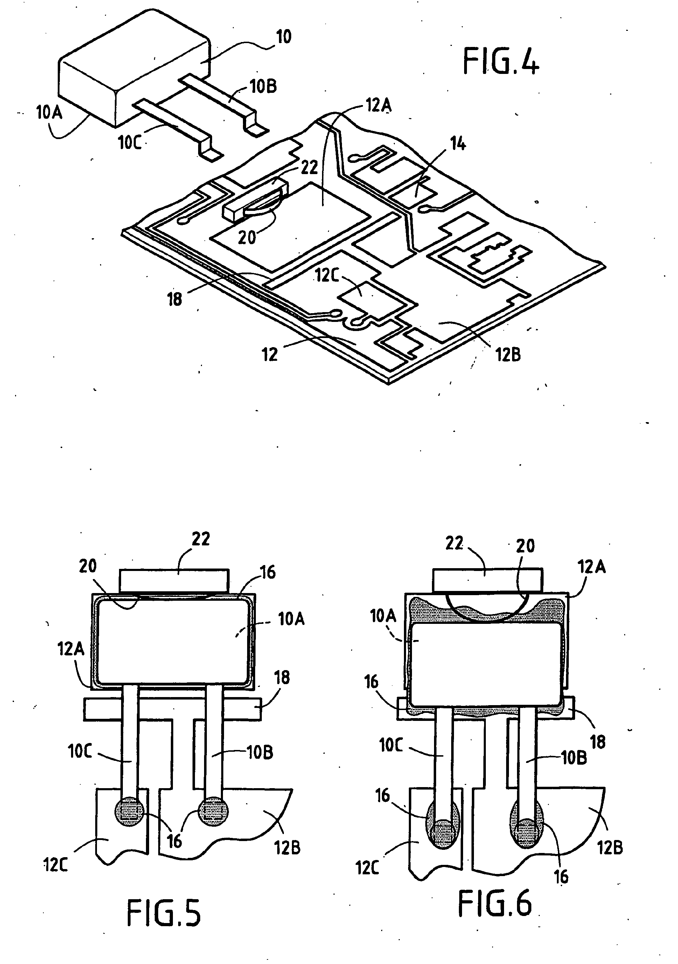

Un second mode de réalisation de l'invention, plus particulièrement destiné à un circuit imprimé disposé en position horizontale, est illustré à la figure 4. Dans cette position (illustrée également à la figure 5), l'effet de la gravité ne joue pas et il est donc nécessaire de forcer le déplacement du composant de puissance 10 de sa première position dans laquelle il est opérationnel vers une seconde position dans laquelle il est mis en court-circuit. Pour cela, il est prévu que celui-ci soit appuyé sur un moyen élastique, par exemple une lame ressort 20, monté contre une paroi de référence 22 solidaire du circuit imprimé 12. Lorsque les brasures vont fondre sous l'effet de la chaleur dégagée par le composant de puissance (voir la figure 6), la lame ressort va se détendre et pousser le composant de puissance vers la piste supplémentaire 18 (qui dans l'exemple illustré présente une simple forme en T) reliée à la pastille de source 12B qui, comme précédemment, va créer un court-circuit franc avec la pastille de drain 12A. La liaison drain-source du composant de puissance étant mise en contact sous l'effet de ce court-circuit, la puissance développée dans ce composant disparaît instantanément, interrompant tout nouveau dégagement de chaleur.

La présente invention est d'une mise en oeuvre particulièrement aisée et peu coûteuse puisque qu'elle n'affecte essentiellement que le dessin du circuit imprimé. Lorsqu'il n'est pas souhaité adopter une position verticale pour le circuit imprimé, l'adjonction d'un simple élément ressort, éventuellement en matière plastique, suffit à permettre une réalisation de l'invention. Bien entendu, la présente invention ne se limite pas au seul montage d'un MOSFET tel que décrit précédemment. En effet, on peut par analogie envisager de monter sur le circuit imprimé d'autres types de composants de puissance, comme tous composants de type CMS : transistors bipolaires (les broches externes se nomment alors collecteur, émetteur et base), transistors GTO ou thyristors (les broches externes se nomment alors cathode, anode et gâchette), triacs (les broches externes se nomment alors anode 1, anode 2 et gâchette), IGBT (les broches externes se nomment alors collecteur, émetteur et grille) ou encore de simples diodes de puissance qui ne comportent que deux broches externes une cathode et une anode.

## Revendications

1. Plaque de circuit imprimé comportant des composants électroniques montés sur cette plaque (12), dont au moins un composant de puissance (10) comportant au moins une première et une seconde broches externes (10A, 10B, 10C) reliées par des moyens de fixation (16) à des conducteurs (14) imprimés sur cette plaque, **caractérisée en ce qu'**elle comporte en outre une piste conductrice (18) s'étendant depuis une première pastille conductrice (12B) de ladite plaque destinée à recevoir ladite première broche externe du composant de puissance vers une seconde pastille conductrice (12A) de ladite plaque destinée à recevoir ladite seconde broche externe du composant de puissance, et des moyens de déplacement du composant de puissance pour, en cas de fonte desdits moyens de fixation, former un contact électrique entre lesdites première et seconde pastilles conductrices par le déplacement dudit composant, créant un court-circuit entre lesdites première et seconde broches.

2. Plaque de circuit imprimé selon la revendication 1, **caractérisée en ce que** lesdites première et seconde broches externes du composant de puissance comportent des broches de source et de drain.

3. Plaque de circuit imprimé selon la revendication 1, **caractérisée en ce que** lesdites première et seconde broches externes du composant de puissance comportent des broches de collecteur et d'émetteur.

4. Plaque de circuit imprimé selon la revendication 1, **caractérisée en ce que** lesdites première et seconde broches externes du composant de puissance comportent des broches d'anode et de cathode.

5. Plaque de circuit imprimé selon l'une quelconque des revendications 1 à 4, **caractérisée en ce que** ladite piste conductrice supplémentaire présente une forme annulaire entourant ladite pastille conductrice de drain, de collecteur ou de cathode.

6. Plaque de circuit imprimé selon l'une quelconque des revendications 1 à 4, **caractérisée en ce que** ladite piste conductrice
supplémentaire présente une forme en U entourant en partie ladite pastille conductrice de drain, de collecteur ou de cathode.

7. Plaque de circuit imprimé selon l'une quelconque des revendications 1 à 4, **caractérisée en ce que** ladite piste conductrice supplémentaire présente une forme en T entourant en partie ladite pastille conductrice de drain, de collecteur ou de cathode.

8. Plaque de circuit imprimé selon l'une quelconque des revendications 1 à 7, **caractérisée en ce que**, lorsque ladite plaque de circuit imprimé est disposée verticalement, lesdits moyens de déplacement sont constitués par la seule gravité.

9. Plaque de circuit imprimé selon l'une quelconque des revendications 1 à 7, **caractérisée en ce que** lesdits moyens de déplacement comportent un moyen élastique monté sur la plaque isolante et destiné à déplacer le composant de puissance lorsque les brasures qui le maintiennent sur ladite plaque isolante fondent.

10. Plaque de circuit imprimé selon la revendication 9, **caractérisée en ce que** ledit moyen élastique est constitué par une lame ressort (20).

11. Procédé de protection d'une plaque de circuit imprimé (12) contre la surchauffe de composants de puissance (10) montés sur cette plaque et reliés par des moyens de fixation (16) à des conducteurs (14) imprimés sur cette plaque, **caractérisé en ce que**, lorsque lesdits moyens de fixation fondent sous l'effet d'une surchauffe du composant de puissance, on déplace le composant de puissance d'une première position dans laquelle il est opérationnel vers une seconde position dans laquelle il est mis en court-circuit.

12. Procédé de protection d'une plaque de circuit imprimé selon la revendication 11, **caractérisé en ce que** ledit déplacement du composant de puissance est obtenu sous l'effet de la gravité.

13. Procédé de protection d'une plaque de circuit imprimé selon la revendication 11, **caractérisé en ce que** ledit déplacement du composant de puissance est obtenu sous l'action d'un moyen élastique (20).

## Claims

1. Printed circuit board comprising electronic components mounted on this board (12), including at least one power component (10) having at least a first and a second external pins (10A, 10B, 10C) linked by fixing means (16) to conductors (14) printed on this board, **characterized in that** it also includes a conductive track (18) extending from a first conductive pad (12B) of said board intended to receive said first external pin of the power component to a second conductive pad (12A) of said board intended to receive said second external pin of the power component, and means of displacing the power component in order, should said fixing means melt, to form an electrical contact between said first and second conductive pads by the displacement of said component, creating a short circuit between said first and second pins.

2. Printed circuit board according to Claim 1, **characterized in that** said first and second external pins of the power component comprise source and drain pins.

3. Printed circuit board according to Claim 1, **characterized in that** said first and second external pins of the power component comprise collector and emitter pins.

4. Printed circuit board according to Claim 1, **characterized in that** said first and second external pins of the power component comprise anode and cathode pins.

5. Printed circuit board according to any one of Claims 1 to 4, **characterized in that** said additional conductive track has an annular form surrounding said drain, collector or cathode conductive pad.

6. Printed circuit board according to any one of Claims 1 to 4, **characterized in that** said additional conductive track is in the form of a U partly surrounding said drain, collector or cathode conductive pad.

7. Printed circuit board according to any one of Claims 1 to 4, **characterized in that** said additional conductive track is in the form of a T partly surrounding said drain, collector or cathode conductive pad.

8. Printed circuit board according to any one of Claims 1 to 7, **characterized in that**, when said printed circuit board is positioned vertically, said displacement means consist solely of gravity.

9. Printed circuit board according to any one of Claims 1 to 7, **characterized in that** said displacement means comprise an elastic means mounted on the insulating board and intended to displace the power component when the solder joints that maintain it on said insulating board melt.

10. Printed circuit board according to Claim 9, **characterized in that** said elastic means consists of a spring leaf (20).

11. Method of protecting a printed circuit board (12) against the overheating of power components (10) mounted on this board and linked by fixing means (16) to conductors (14) printed on this board, **characterized in that**, when said fixing means melt under the effect of an overheating of the power component, the power component is displaced from a first position in which it is operational to a second position in which it is short-circuited.

12. Method of protecting a printed circuit board according to Claim 11, **characterized in that** said displacement of the power component is obtained under the effect of gravity.

13. Method of protecting a printed circuit board according to Claim 11, **characterized in that** said displacement of the power component is obtained under the action of an elastic means (20).

## Patentansprüche

1. Leiterplatte, die Elektronikbauteile aufweist, die auf diese Leiterplatte (12) montiert sind, von welchen mindestens ein Leistungsbauteil (10) mindestens einen ersten und einen zweiten externen Kontaktstift (10A, 10B, 10C) aufweist, die durch Befestigungsmittel (16) mit Leitern (14), die auf diese Leiterplatte gedruckt sind, verbunden sind, **dadurch gekennzeichnet, dass** sie ferner eine Leiterbahn (18) aufweist, die sich von einem ersten Lötauge (12B) der Leiterplatte, das dazu bestimmt ist, den ersten externen Kontaktstift des Leistungsbauteils aufzunehmen, zu einem zweiten Lötauge (12A) der Platte, das dazu bestimmt ist, den zweiten externen Kontaktstift des Leistungsbauteils aufzunehmen, erstreckt, und Mittel zum Verlagern des Leistungsbauteils, um, im Fall des Schmelzens der Befestigungsmittel, einen elektrischen Kontakt zwischen dem ersten und dem zweiten Lötauge durch die Verlagerung des Bauteils, die einen Kurzschluss zwischen dem ersten und dem zweiten Kontaktstift erzeugt, zu bilden.

2. Leiterplatte nach Anspruch 1, **dadurch gekennzeichnet, dass** der erste und der zweite externe Kontaktstift des Leistungsbauteils Quell- und Drainkontaktstifte aufweisen.

3. Leiterplatte nach Anspruch 1, **dadurch gekennzeichnet, dass** der erste und der zweite externe Kontaktstift des Leistungsbauteils Kollektor- und Senderkontaktstifte aufweisen.

4. Leiterplatte nach Anspruch 1, **dadurch gekennzeichnet, dass** der erste und der zweite externe Kontaktstift des Leistungsbauteils Anoden- und Kathodenkontaktstifte aufweisen.

5. Leiterplatte nach einem der Ansprüche 1 bis 4, **dadurch gekennzeichnet, dass** die zusätzliche Leiterbahn eine Ringform aufweist, die das Drain-, Kollektor- oder Kathodenlötauge umgibt.

6. Leiterplatte nach einem der Ansprüche 1 bis 4, **dadurch gekennzeichnet, dass** die zusätzliche Leiterbahn eine U-Form aufweist, die zum Teil das Drain-, Kollektor- oder Kathodenlötauge umgibt.

7. Leiterplatte nach einem der Ansprüche 1 bis 4, **dadurch gekennzeichnet, dass** die zusätzliche Leiterbahn eine T-Form aufweist, die zum Teil das Drain-, Kollektor- oder Kathodenlötauge umgibt.

8. Leiterplatte nach einem der Ansprüche 1 bis 7, **dadurch gekennzeichnet, dass**, wenn die Leiterplatte vertikal angeordnet ist, die Mittel zum Verlagern allein aus der Schwerkraft bestehen.

9. Leiterplatte nach einem der Ansprüche 1 bis 7, **dadurch gekennzeichnet, dass** die Mittel zum Verlagern ein elastisches Mittel aufweisen, das auf die isolierende Platte montiert und dazu bestimmt ist, den Leistungsbauteil zu verlagern, wenn die Lötungen, die ihn auf der isolierenden Platte halten, schmelzen.

10. Leiterplatte nach Anspruch 9, **dadurch gekennzeichnet, dass** das elastische Mittel aus einem Federblatt (20) besteht.

11. Schutzverfahren einer Leiterplatte (12) gegen Überhitzung von Leistungsbauteilen (10), die auf diese Platte montiert und durch Befestigungsmittel (16) mit Leitern (14), die auf diese Leiterplatte gedruckt sind, verbunden sind, **dadurch gekennzeichnet, dass** man, wenn die Befestigungsmittel unter der Einwirkung einer Überhitzung des Leistungsbauteils schmelzen, den Leistungsbauteil von einer ersten Position, in der er betriebsfähig ist, zu einer zweiten Position, in der er kurzgeschlossen wird, verlagert.

12. Schutzverfahren einer Leiterplatte nach Anspruch 11, **dadurch gekennzeichnet, dass** die Verlagerung des Leistungsbauteils unter der Einwirkung der Schwerkraft erzielt wird.

13. Schutzverfahren einer Leiterplatte nach Anspruch 11, **dadurch gekennzeichnet, dass** die Verlagerung des Leistungsbauteils unter der Einwirkung eines elastischen Mittels (20) erzielt wird.
